# EUROPEAN PATENT SPECIFICATION

(11) **EP 3 182 467 B1**
(45) Date of publication and mention of the grant of the patent: **25.12.2019**
(21) Application number: 15460115.7
(22) Date of filing: 15.12.2015
(51) Int. Cl.: H01L 31/048, H02S 20/22

(54) **A BLIND SLAT FOR A PHOTOVOLTAIC MODULE AND A METHOD OF JOINING IT WITH THE MODULE**
BLENDENLAMELLE FÜR PHOTOVOLTAISCHES MODUL UND VERFAHREN ZUR VERBINDUNG DAVON MIT DEM MODUL
LAME DE STORE POUR MODULE PHOTOVOLTAÏQUE ET PROCÉDÉ D'ASSEMBLAGE AVEC CE MODULE

(43) Date of publication of application: 21.06.2017
(73) Proprietor: ML SYSTEM Spólka Akcyjna, 36-062 Zaczernie (PL)
(72) Inventor: Cycon, Dawid, 35-317 Rzeszów (PL); Chochorowski, Wiktor, 35-111 Rzeszów (PL); Stanek, Olga, 35-506 Rzeszów (PL); Stanek, Edyta, 35-317 Rzeszów (PL)
(74) Representative: Warzybok, Tadeusz

(56) References cited:
- WO-A2-2013/062576
- DE-A1-102011 009 879
- US-A- 5 221 363
- US-A- 5 258 076
- US-A1- 2011 146 753
- US-A1- 2015 155 410

## Description

The subject of the invention is a blind-slat photovoltaic module, to be applied especially in sunshade systems with blinds.

Polish patent application No. P-405630 reveals a system of sunshades with blinds equipped with, among other things, photovoltaic modules, where each of the modules comprises an element shielding element a blind slat fixed on a two-piece fixing holder by means of U-shaped gasket pressed by means of screws against both ends of the blind slat also bent to give them a U-shape. Both portions of the holder form between them a square opening in which a lock is mounted with identical shape, joined with vertical angles of the holder detachably by means of screws.

Description of Polish patent No. PL207060B1 teaches a glass laminate containing a layer of polyvinyl butyral, a polymer layer, and a layer of shatter-resistant glass, which is characterised in that it contains:
- a first layer of plasticised polyvinyl butyral having an upper surface and a lower surface;
- a first polyurethane layer adjacent to lower surface of the first layer;
- a second polyurethane layer adjacent to upper surface of the first layer, whereas at least one from among the first polyurethane layer and the second polyurethane layer contains plasticisers of polyurethane with thickness less than 0.125 mm;
- a first glass layer adjacent to the second polyurethane layer and the second glass layer adjacent to the first polyurethane layer, whereas both polyurethane layers of said glass laminate contain polyurethane with thickness less than 0.125 mm.

The glass laminate according the quoted invention contains glass panes which can constitute an arbitrary combination of arbitrary types of glass, including both transparent glasses and tinted glass as well as annealed, thermally reinforced or tempered glass.

Further, description of utility model No. CN201084738Y reveals a photovoltaic layered laminated glass containing two outermost glass panes inner surfaces of which are shielded with adhesive layers, and between them a solar panel is placed provided with electric leads, whereas the glass panes have thickness from 1.5 mm to 25 mm, and thickness of the adhesive layer is 0.76 mm.

Description of patent US 2015/0121780A1 discloses a walkable photovoltaic floor constituted of pieces of laminated glass composed of at least two layers of glass joined together by an encapsulant and an intermediate photovoltaic layer made of crystalline silicon cells connected between each other forming strings encapsulated between polymeric foils, then laminated between two glazing lites and placed in a frame sealed peripherally with silicone.

Description of invention protected with patent EP2346092A1 teaches a photovoltaic module with photovoltaic cell having a reflexive insulating element provided on its surface, so the reflective insulating element is disposed between the plate and the photoelectric cell. The reflective element is a heat-insulating film, a multi-layer heat-insulation film patch, a polyester thin film, or a low-emissive glass. The photovoltaic cell of the module is a solar panel selected from a group consisting of an amorphous silicon solar panel, a monocrystalline silicon solar panel and a polysilicon solar panel.

Further, patent description WO 02/101839 A1 discloses a photovoltaic tile comprising a supporting structure adapted to be fixedly secured to a building framework and a removable outer panel which substantially covers the support structure in the fully assembled position. The outer panel assembly incorporates photovoltaic cells which are connected to an electrical connector with a junction box of the supporting frame adapted to provide connections to electrical output leads.

US5221363 describes a window with photovoltaic blind-slats.

The objective of the invention is to provide a new design for a blind-slat for photovoltaic module with significantly reduced own weight, high mechanical strength, and resistance to atmospheric conditions, allowing to reduce overall dimensions and reduce the mass of supporting structures for sunshades with blinds and other structures on which it is possible to install the module according to the invention.

The essential idea behind the blind-slat photovoltaic module according to the invention is characterised by the features defining the subject-matter of claim 1.

It is favourable when the absorber constitutes quantum dots (QDSC).

It is also favourable when the glass laminate of the module rests on two offsets of a lock having, in its transversal cross section, the form of a rectangular tube and fixed in a two-piece metal holder provided with vertical offsets, whereas rubber spacing elements are disposed between said offsets and both of the two ends of the laminate.

By equipping the blind-slat photovoltaic module according to the invention with a multi-layered laminate containing layers in the form of glass panes with thickness from 0.5 mm to 1.8 mm of the so-called thin glass, allowed to reduce significantly the weight of the module, reduce overall dimensions, and reduce the weight of the whole system of sunshades with blind slats and similar structures in which it is possible to install such layered laminate. On the other hand, the use of thin glass strengthened chemically in salt bath as a component of layered laminate allowed to increase the mechanical strength several times and increase resistance to variable atmospheric conditions, including hailstorm.

By using photovoltaic cells manufactured with the use of technologies based on up-to-date transparent absorbers such as (DSSC), perovskites (PSC), or quantum dots in the blind slat according to the invention allows to adjust translucency of such blind slat in a wide range. The use of absorbers of that type is favourable also in view of small loss of cell efficiency in case of adverse angle of incidence of sunrays which is a phenomenon quite likely in case of integrating cells in blind-slat photovoltaic modules.

The subject of the invention is presented by means of its example embodiments and on drawings, of which Fig. 1 presents the blind-slat photovoltaic module in the vertical cross-section; Fig. 2 - a simplified blind-slat photovoltaic module joined with its lock and holder in the vertical cross-section; Fig. 3 - the same module in the side view; Fig. 4 - the blind-slat photovoltaic module with the two-piece holder of its lock, in the vertical cross-section; Fig. 5 - the same module in an embodiment with a variation of the two-piece lock with its holder, in the vertical cross-section.

### Example 1

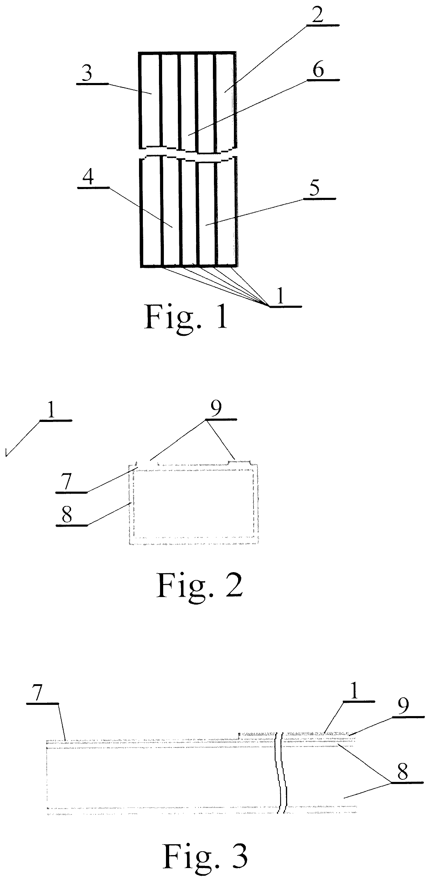

As shown in Figure 1, the blind-slat photovoltaic module constitutes a laminate 1 having a layered structure composed of two outer layers 2 and 3 which constitute glass panes with thickness 1.0 mm joined with each other permanently by means of two layers of lamination films 4 and 5 disposed between them and with a layer of photovoltaic cells 6 disposed between said films and permanently joined with them.

### Example 2

The laminate 1 has layered structure analogous to this described in Example 1, and the only difference in its structure consists in that its outer layer 2 is made of glass pane with thickness 0.5 mm, and the second outer layer 3 is made of glass pane with thickness 1.8 mm.

### Example 3, not part of the invention

Laminate 1 (not shown in figures) lacks the layer of photovoltaic cells 6 and comprises only two outer layers 2 and 3 which are panes of laminated glass with thickness 0.7 mm joined with each other permanently only by means of a single layer of lamination film.

### Example 4, not part of the invention

The laminate 1, not shown in the figures, comprises only one layer being a glass pane with thickness 1.5 mm.

In all example embodiments 1-4 of laminate 1, the used glass was strengthened by means of chemical method consisting in immersing glass panes in salt bath and larding their surfaces with larger ions under pressure.

### Example 5, not part of the invention

As shown in Figs. 2 and 3, the blind-slat photovoltaic module has laminate 1 without photovoltaic cells 6 which is joined permanently with two offsets 7 of lock 8 having the form of tube with rectangular cross-section by means of silicone 9.

### Example 6

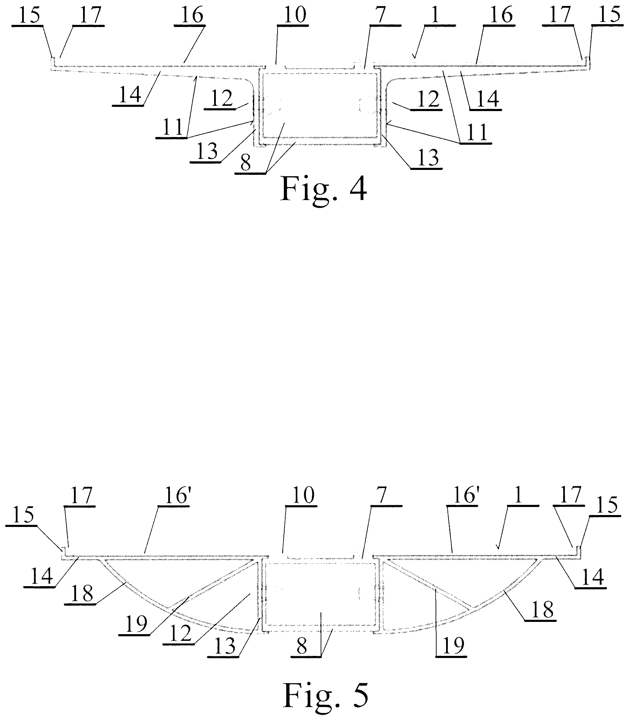

The blind-slat photovoltaic module shown in Fig. 4 has laminate 1 joined permanently with two offsets 7 of lock 8, by means of double-sided highly-adhesive tape 10, whereas lock 8 is fixed in a two-piece metal holder 11 and attached by means of screws 12 to its vertical angle arms 13, both horizontally oriented trapezoidal supporting arms 14 of which are provided with vertical offsets 15 at their ends, whereas laminate 1 is disposed between said offsets and joined additionally with upper surfaces of said arms by means of layers of structural silicone 16, whereas between both ends of the laminate 1 and vertical offsets 15 disposed are rubber spacing elements 17 preventing said laminate from moving and protecting its glass edges against contact with metal elements of horizontal trapezoidal arms 14 of the metal holder 11 which could damage the glass of laminate 1 as a result of thermal expansion occurring in both the laminate and the metal elements.

### Example 7

The blind-slat photovoltaic module shown in Fig. 5 has structure identical to this of the module slat shown in Fig. 4, except for the shape of the two-piece metal holder 11, with lower ends of vertical arms 13 of the holder are joined with its supporting arms 14 by means of elements 18 with profiles representing circular segments with inner stiffening ribs 19 and the means joining additionally the laminate 1 with upper surfaces of horizontal arms 14 of the holder, said means in this embodiment being a photo-setting adhesive 16'.

### Example 6

The blind slat for photovoltaic module shown in Fig. 4 has laminate 1 joined permanently with two offsets 7 of lock 8, by means of double-sided highly-adhesive tape 10, whereas lock 8 is fixed in a two-piece metal holder 11 and attached by means of screws 12 to its vertical angle arms 13, both horizontally oriented trapezoidal supporting arms 14 of which are provided with vertical offsets 15 at their ends, whereas laminate 1 is disposed between said offsets and joined additionally with upper surfaces of said arms by means of layers of structural silicone 16, whereas between both ends of the laminate 1 and vertical offsets 15 disposed are rubber spacing elements 17 preventing said laminate from moving and protecting its glass edges against contact with metal elements of horizontal trapezoidal arms 14 of the metal holder 11 which could damage the glass of laminate 1 as a result of thermal expansion occurring in both the laminate and the metal elements.

### Example 7

The blind slat for photovoltaic module shown in Fig. 5 has structure identical to this of the photovoltaic blind slat shown in Fig. 4, except for the shape of the two-piece metal holder 11, with lower ends of vertical arms 13 of the holder are joined with its supporting arms 14 by means of elements 18 with profiles representing circular segments with inner stiffening ribs 19 and the means joining additionally the laminate 1 with upper surfaces of horizontal arms 14 of the holder, said means in this embodiment being a photo-setting adhesive 16'.

## Claims

1. (new) A blind-slat photovoltaic module for a sunshade with blinds, said module comprising a glass laminate (1) in the form of flat panes with laminar structure comprising a layer of photovoltaic cells (6) disposed between two outer layers which are glass panes (2, 3) with thickness from 0.5 mm to 1.8 mm strengthened chemically in salt bath, laminated together by means of two layers of lamination films (4, 5), wherein in the glass laminate (1) the layer of photovoltaic cells is disposed between the layers of lamination films (4, 5), and where the layer of photovoltaic cells has an absorber, preferably perovskyte.

2. The blind-slat photovoltaic module according to claim 1 **characterised in that** the absorber for the photovoltaic cell disposed in the laminate (1) are quantum dots (QDSC).

3. The blind-slat photovoltaic module according to claim 1 **characterised in that** the absorber for the photovoltaic cell disposed in the laminate is a dye-sensitised solar cell (DSSC).

4. (new) The blind-slat photovoltaic module according to claim 1 **characterised in that** its glass laminate (1) rests on two offsets (7) of a lock (7) having, in its transverse cross-section, the shape of a rectangular tube and fixed in a two-piece metal holder (11) provided with vertical offsets (15), whereas between said offsets and both ends of the laminate (1) rubber spacing elements (17) are disposed, and wherein the laminate of the blind slat is joined inseparably with the offsets (7) of the lock (8) by means of double-sided highly adhesive tape (10).

5. (new) The blind-slat photovoltaic module according to claim 4 **characterised in that** the glass laminate (1) is joined inseparably with horizontal supporting arms (14) of the two-piece metal holder (11) by means of a layer of a photo-setting adhesive (16') or a layer of structural silicone (16) or a layer of a double-sided adhesive tape (10).

## Patentansprüche

1. Das Photovoltaik-Modul der Jalousie-Lamellen zum Sonnenschutz mit Jalousien, das genannte Modul enthaltend Glaslaminat (1) in Form von flachen Scheiben mit der laminaren Struktur mit einer Schicht der photovoltaischen Zellen (6), die zwischen zwei äußeren Schichten verlegt ist, welche die Glasscheiben (2, 3) mit der Dicke von 0,5 mm bis 1,8 mm sind, chemisch im Salzbad verstärkt, laminiert zusammen mit Hilfe von zwei Schichten der Laminierfolie (4, 5), wobei im Glaslaminat (1) eine Schicht der photovotaischen Zellen zwischen den Schichten der Laminierfolie (4, 5) verlegt ist und wo eine Schicht der photovotaischen Zellen einen Absorber, vorteilhaft Perowskit aufweist.

2. Das Photovoltaik-Modul der Jalousie-Lamellen nach dem Anspruch 1, **dadurch gekennzeichnet, dass** den Absorber für die photovoltaischen Zelle, die im Laminat (1) verlegt ist, die Quantenpunkte (QDSC) bilden.

3. Das Photovoltaik-Modul der Jalousie-Lamellen nach dem Anspruch 1, **dadurch gekennzeichnet, dass** den Absorber für die photovoltaischen Zelle, die im Laminat (1) verlegt ist, die farbstoffsensibilisierte Solarzelle (DSSC) bildet.

4. Das Photovoltaik-Modul der Jalousie-Lamellen nach dem Anspruch 1, **dadurch gekennzeichnet, dass** sein Glaslaminat (1) auf zwei Versätzen (7) einer Verriegelung (7) ruht, mit der Form des Rechteckrohres in seinem Querschnitt und im zweiteiligen Metallhalter (11) befestigt ist, ausgerüstet mit vertikalen Versätzen (15), während zwischen den beiden genannten Versätzen und den beiden Enden des Laminats (1) die Gummi-Abstandselemente (17) verlegt sind und wo das Laminat der Jalousie-Lamellen mit den Versätzen (7) der Verriegelung (8) mit Hilfe des doppelseitigen starken Klebebandes (10) untrennbar verbunden ist.

5. Das Photovoltaik-Modul der Jalousie-Lamellen nach dem Anspruch 4, **dadurch gekennzeichnet, dass** das Glaslaminat (1) mit horizontalen Tragarmen (14) des zweiteiligen Metallhalters (11) mit Hilfe einer Schicht des photohärtbaren Bindemittels (16') oder einer Schicht des strukturellen Silikons (16) oder einer Schicht des doppelseitigen Klebebandes (10) untrennbar verbunden ist.

## Revendications

1. Module photovoltaïque de lamelles de store vénitien pare-soleil, où ce module contient du verre laminé (1) sous forme de feuilles plates à structure laminaire comprenant une couche de cellules photovoltaïques (6) prise en sandwich entre deux couches extérieures qui sont des vitres (2, 3) avec une épaisseur de 0,5 à 1,8 mm renforcées chimiquement dans un bain de sel, laminées avec deux feuilles de laminage (4, 5), où une couche de cellules photovoltaïques est disposée dans ce verre laminé (1) entre deux feuilles de laminage (4, 5) et cette couche de cellules photovoltaïques possède un corps absorbant, de préférence de la pérovskite.

2. Module photovoltaïque de lamelles de store vénitien selon la révendication 1 **caractérisé en ce que** ce sont les points quantiques (QDSC) qui servent d' absorbeur.

3. Module photovoltaïque de lamelles de store vénitien selon la révendication 1 **caractérisé en ce que** l'absorbeur des cellules photovoltaïques disposées dans ce laminé (1) est une cellule solaire sensibilisée au colorant (DSSC).

4. Module photovoltaïque de lamelles de store vénitien selon la révendication 1 **caractérisé en ce que** le verre laminé (1) repose sur deux ressauts (7) d'un verrou (7) ayant dans sa section transversale la forme d'un tube rectangulaire et fixé dans une poignée en métal de deux parties (11) équipée des ressauts verticaux (15), tandis qu'entre ces ressauts et les deux extrémités du verre laminé (1) sont placés les éléments d'écartement en caoutchouc (17) et le laminé de lamelles de store vénitien est inséparablement joint aux ressauts (7) d'un verrou (8) au moyen de ruban hautement adhésif double face (10).

5. Module photovoltaïque de lamelles de store vénitien selon la révendication 4 **caractérisé en ce que** le verre laminé (1) est inséparablement joint aux bras de support horizontaux (14) d'une poignée en métal de deux parties (11) utilisant une couche de liant photopolymérisable (16') ou bien une couche de silicone structural (16) ou encore une couche de ruban adhésif double face (10).
